# FASCICULE DE BREVET EUROPEEN

(11) **EP 3 394 882 B1**
(45) Date de publication et mention de la délivrance du brevet: **11.08.2021**
(21) Numéro de dépôt: 16829269.6
(22) Date de dépôt: 21.12.2016
(51) Int. Cl.: H01L 21/762, H01L 29/78

(54) **CIRCUIT ELECTRONIQUE COMPRENANT DES TRANCHEES D'ISOLATION ELECTRIQUE**
ELEKTRONISCHE SCHALTUNG MIT ELEKTRISCH ISOLIERENDEN GRÄBEN
ELECTRONIC CIRCUIT COMPRISING ELECTRICALLY INSULATING TRENCHES

(30) Priorité: 24.12.2015 FR 1563330
(43) Date de publication de la demande: 31.10.2018
(73) Titulaire: Aledia, 38130 Echirolles (FR); Commissariat à l'Energie Atomique et aux Energies Alternatives, 75015 Paris (FR)
(72) Inventeur: GOUTAUDIER, Fabienne, 38000 Grenoble (FR); LACAVE, Thomas, 38000 Grenoble (FR); BEIX, Vincent, 73000 Chambery (FR); BOREL, Stephan, 38920 Crolles (FR); CHAMBION, Bertrand, 38530 Pontcharra (FR); SOULIER, Brigitte, 38000 Grenoble (FR)
(74) Mandataire: Cabinet Beaumont
(86) Numéro de dépôt international: PCT/FR2016/053618
(87) Numéro de publication internationale: WO 2017/109415

(56) Documents cités:
- US-A- 5 448 102
- US-A1- 2011 049 668
- US-A1- 2012 098 084
- US-A1- 2015 118 823

## Description

La présente demande de brevet revendique la priorité de la demande de brevet français FR15/63330.

### Domaine

La présente demande concerne un circuit électronique comprenant des tranchées d'isolation électrique.

### Exposé de l'art antérieur

De façon générale, un circuit électronique comprend un substrat conducteur ou semiconducteur dans lequel et sur lequel sont formés des composants électroniques. Pour certaines applications, il est souhaitable d'isoler électriquement les unes des autres différentes portions du substrat. Ceci peut être obtenu en formant dans le substrat des tranchées isolantes électriquement qui s'étendent sur la totalité de l'épaisseur du substrat et qui divisent le substrat en portions isolées électriquement les unes des autres.

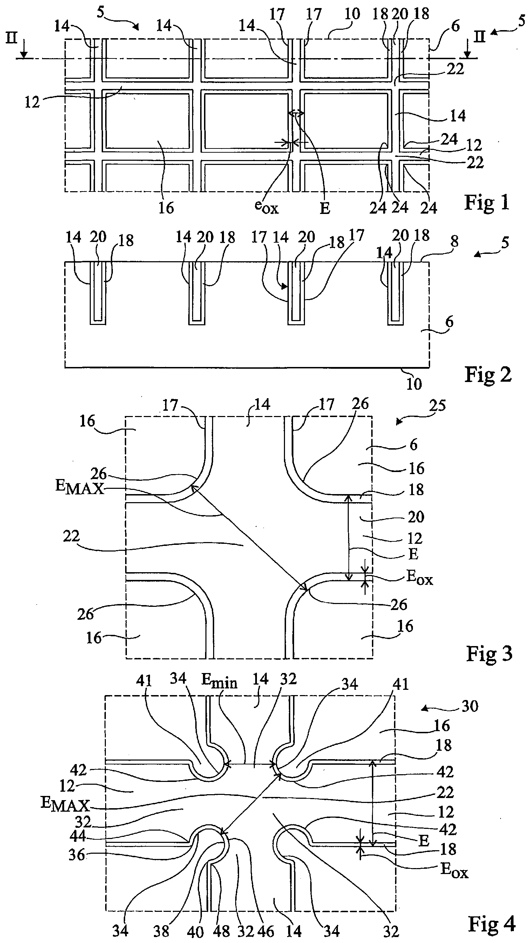

La figure 1 est une vue de dessus, partielle et schématique, d'un exemple de circuit électronique 5 et la figure 2 est une vue en coupe de la figure 1 selon la ligne II-II. Le circuit électronique 5 comprend un substrat semiconducteur ou conducteur 6 ayant des faces 8, 10 opposées et comprend en outre, dans le substrat 6, des tranchées d'isolation électrique 12, 14 qui s'entrecroisent et délimitent des portions 16 du substrat 6. Les tranchées 12 s'étendent en vue de dessus selon une première direction et les tranchées 14 s'étendent en vue de dessus selon une deuxième direction inclinée par rapport à la première direction, par exemple perpendiculaire à la première direction. Les tranchées 12, 14 ont sensiblement la forme de bandes en vue de dessus. Les tranchées 12, 14 s'étendent dans le substrat 6 depuis la face 8 sur une partie ou sur la totalité de l'épaisseur du substrat 6.

A titre d'exemple, chaque tranchée 12, 14 comprend deux parois latérales 17 opposées sensiblement planes, par exemple sensiblement parallèles, recouvertes d'une couche isolante électriquement 18 d'épaisseur E_{OX}, le coeur 20 de la tranchée 12, 14 étant rempli d'un matériau de remplissage, par exemple un matériau semiconducteur. A titre de variante, chaque tranchée 12, 14 peut être remplie complètement d'un matériau isolant électriquement. La largeur E de chaque tranchée 12, 14 correspond à la distance entre les deux parois 17 opposées de la tranchée.

A chaque intersection 22 entre l'une des tranchées 12 et l'une des tranchées 14, les parois latérales 17 de la tranchée 12 sont sensiblement perpendiculaires aux parois latérales 17 de la tranchée 14. Un inconvénient d'un tel circuit électronique 5 est que les intersections 22 sont des zones de concentration de contraintes, de sorte que des fissures tendent à se former dans le substrat à ces emplacements. Plus précisément, les zones de concentration de contraintes se situent à chaque arête 24 entre les parois latérales 17 de la tranchée 12 et les parois latérales 17 de la tranchée 14.

La figure 3 est une vue de dessus, partielle et schématique, d'un autre exemple de circuit électronique 25 qui comprend l'ensemble des éléments du circuit électronique 5 représenté en figure 1 à la différence que, pour chaque intersection 22, chaque arête 24 de l'intersection 22 est remplacée par une zone de jonction arrondie 26, la couche isolante 18 épousant la forme de la zone arrondie 26. De ce fait, chaque tranchée 12, 14 s'évase au niveau de l'intersection 22. Les zones arrondies 26 permettent de réduire, voire de supprimer, les zones de concentration de contraintes.

Un inconvénient du circuit électronique 5 et 25 est que la largeur maximale E_{MAX} à l'intersection 22 est supérieure à la largeur E de chaque tranchée 12, 14 en dehors de l'intersection 22. Le phénomène est davantage marqué pour le circuit électronique 25 avec la présence des zones arrondies 26 diamétralement opposées par rapport au centre de l'intersection 22. A titre d'exemple, pour une largeur E d'environ 2 µm, la largeur maximale E_{MAX} peut être d'environ 2,8 µm. Le remplissage du coeur 20 des tranchées 12, 14 peut alors être délicat à mettre en oeuvre. En effet, lorsque le remplissage du coeur des tranchées 12, 14 est réalisé par un dépôt conforme du matériau de remplissage sur la totalité du circuit électronique 5, l'épaisseur déposée doit être celle qui permet le remplissage du coeur 20 des tranchées 12, 14 à la largeur E_{MAX}, c'est-à-dire plus importante que l'épaisseur permettant le remplissage du coeur 20 des tranchées 12, 14 à la largeur E. Ceci peut entraîner la formation de surépaisseurs du matériau de remplissage sur le circuit électronique qui peuvent être difficiles à retirer.

Un autre inconvénient du circuit électronique 25 est que les zones arrondies 26 entraînent une réduction de la surface des portions semiconductrices ou conductrices 16 utilisées pour la formation de composants électroniques. Les documents US2015/0118823 A1, US 5448102 et US2009/0294893 A1 décrivent tous un substrat semiconducteur pour circuit électronique comprenant des première et deuxième tranchées qui délimitent des portions de substrat.

### Résumé

Un objet d'un mode de réalisation est de pallier tout ou partie des inconvénients des circuits électroniques décrits précédemment.

Un autre objet d'un mode de réalisation est de réduire l'intensité maximale des contraintes au niveau des intersections entre les tranchées d'isolation électrique.

Un autre objet d'un mode de réalisation est que la largeur maximale des intersections entre les tranchées d'isolation électrique n'est pas supérieure à la largeur des tranchées d'isolation électrique en dehors des intersections.

Un autre objet d'un mode de réalisation est que la surface, en vue de dessus, des portions du substrat délimitées par les tranchées d'isolation électrique n'est pas réduite par rapport à la surface de portions délimitées par des tranchées d'isolation électrique se croisant à 90°.

Un autre objet d'un mode de réalisation est que le procédé de remplissage des tranchées d'isolation électrique n'est pas modifié par rapport au procédé mis en oeuvre dans le cas de tranchées d'isolation électrique se croisant à 90°.

Un autre objet d'un mode de réalisation est que le procédé de retrait du matériau de remplissage des tranchées en excès, par exemple par gravure humide, sèche ou par polissage mécano-chimique (CMP, sigle anglais pour Chemical-Mechanical Planarization), n'est pas modifié par rapport au cas où les tranchées se croisent à 90°, de façon à ne pas ajouter de temps de traitement supplémentaire au procédé de fabrication.

Ainsi, un mode de réalisation prévoit un circuit électronique comprenant un substrat semiconducteur ou conducteur ayant des première et deuxième faces opposées et au moins des première et deuxième tranchées d'isolation électrique, non parallèles, s'étendant dans le substrat depuis la première face, délimitant au moins une portion du substrat et se rejoignant à une jonction, la portion du substrat comprenant une protubérance pénétrant dans la jonction.

Selon un mode de réalisation, la première tranchée comprend, du côté de ladite portion, une première paroi plane. La deuxième tranchée comprend, du côté de ladite portion, une deuxième paroi plane, la première paroi plane étant reliée à la deuxième paroi plane par une surface de liaison comprenant successivement, de la première paroi jusqu'à la deuxième paroi, une première surface courbe délimitant une portion de volume convexe de la première tranchée, une deuxième surface courbe délimitant une portion de volume concave de la jonction et une troisième surface courbe délimitant une portion de volume convexe de la deuxième tranchée.

Selon un mode de réalisation, le rayon de courbure de la deuxième surface est compris entre 200 nm et 2 µm.

Selon un mode de réalisation, les première, deuxième et troisième surfaces correspondent, dans un plan parallèle à la première face, respectivement à des premier, deuxième et troisième arcs de cercle.

Selon un mode de réalisation, le centre du premier arc de cercle est situé dans la première tranchée, le centre du deuxième arc de cercle est situé dans la portion et le centre du troisième arc de cercle est situé dans la deuxième tranchée.

Selon un mode de réalisation, ladite jonction correspond à une intersection entre les première et deuxième tranchées, la première tranchée ayant une section droite de largeur réduite de part et d'autre de l'intersection et la deuxième tranchée ayant une section droite de largeur réduite de part et d'autre de l'intersection.

Selon un mode de réalisation, la surface de liaison est reproduite aux quatre coins de l'intersection.

Selon un mode de réalisation, les parois des première et deuxième tranchées sont recouvertes d'une couche d'un premier matériau isolant électriquement, le coeur des première et deuxième tranchées étant rempli d'un deuxième matériau pouvant être différent du premier matériau.

Selon un mode de réalisation, l'interface entre la couche isolante et le coeur comprend successivement des quatrième, cinquième et sixième surfaces qui épousent respectivement la forme des première, deuxième et troisième surfaces.

Selon un mode de réalisation, le rayon de courbure de la quatrième surface et de la sixième surface est compris entre 100 nm et 1 µm.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1, 2 et 3, décrites précédemment, sont des vues, partielles et schématiques, d'exemples de circuits électroniques comprenant des tranchées d'isolation électrique ;
la figure 4 est une vue de dessus, partielle et schématique, d'un mode de réalisation d'un circuit électronique comprenant des tranchées d'isolation électrique ;
la figure 5 représente la courbe d'évolution C de la contrainte maximale dans le circuit électronique représenté en figure 4 en fonction du rayon de courbure de la couche isolante de la tranchée d'isolation électrique à l'intersection entre deux tranchées d'isolation électrique ;
la figure 6 est une vue de dessus, partielle et schématique, d'un mode de réalisation d'un circuit électronique illustrant la jonction entre deux tranchées d'isolation électrique dans un coin du circuit ;
la figure 7 est une vue de dessus, partielle et schématique, d'un autre mode de réalisation d'un circuit électronique illustrant la jonction entre deux tranchées d'isolation électrique dans un coin du circuit ;
la figure 8 est une vue de dessus, partielle et schématique, d'un autre mode de réalisation d'un circuit électronique comprenant des tranchées d'isolation électrique ;
les figures 9A à 9E représentent les structures obtenues à des étapes successives d'un mode de réalisation d'un procédé de fabrication du circuit électronique représenté en figure 4 ; et
les figures 10A, 10B et 10C sont respectivement une vue de dessus, une vue de face avec coupe et une vue de dessous, partielles et schématiques, d'un mode de réalisation d'un dispositif optoélectronique à diodes électroluminescentes.

### Description détaillée

De mêmes éléments ont été désignés par de mêmes références aux différentes figures. Par souci de clarté, seuls les éléments qui sont utiles à la compréhension des modes de réalisation décrits ont été représentés et sont détaillés. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures. Sauf précision contraire, les expressions "approximativement", "sensiblement", et "de l'ordre de" signifient à 10 % près, de préférence à 5 % près. Dans la suite de la description, on appelle "matériau isolant électriquement" un matériau dont la résistivité est supérieure à 10⁵ Ω.m, on appelle "matériau semiconducteur" un matériau dont la résistivité électrique est comprise entre 0,1 Ω.m et 10³ Ω.m et on appelle "matériau conducteur" un matériau dont la résistivité électrique est inférieure à 10⁻³ Ω.m.

La figure 4 est une vue analogue à la figure 3 et représente un mode de réalisation d'un circuit électronique 30. Le circuit électronique 30 comprend l'ensemble des éléments du circuit électronique 25 représenté en figure 3 à la différence que, pour chaque intersection 22, au lieu de s'évaser, chaque tranchée 12, 14 comprend une zone d'étranglement 32 de part et d'autre de l'intersection 22. De ce fait, pour chaque intersection 22, il y a quatre zones d'étranglement 32. On appelle Eₘᵢₙ la largeur minimale de la tranchée 12, 14 au niveau de la zone d'étrangement 32. Deux zones d'étranglement 32 sont situées sur la tranchée 12 de part et d'autre de l'intersection 22 et deux zones d'étranglement 32 sont situées sur la tranchée 14 de part et d'autre de l'intersection 22. Chaque zone d'étranglement 32 est délimitée par deux surfaces 34, appelées oreilles par la suite, qui pénètrent dans la tranchée 12, 14 et qui sont situées à chaque jonction d'une paroi latérale 17 de la tranchée 12 avec une paroi latérale 17 de la tranchée 14.

Selon un mode de réalisation, chaque oreille 34 comprend successivement, depuis la paroi plane 17 de la tranchée 12 jusqu'à la paroi plane 17 de la tranchée 14, une première surface courbe 36, une deuxième surface courbe 38 et une troisième surface courbe 40. La première surface courbe 36 délimite une portion de volume convexe de la tranchée 12. Un volume est convexe si, pour tous points A et B du volume, tous les points du segment [AB] appartiennent au volume. Selon un mode de réalisation, dans le plan de coupe de la figure 4, la section de la première surface courbe 36 correspond à un arc de cercle dont le centre est à l'intérieur de la tranchée 12. La deuxième surface courbe 38 délimite une portion de volume concave, c'est-à-dire non convexe, de l'intersection 22. Selon un mode de réalisation, dans le plan de coupe de la figure 4, la section de la deuxième surface courbe 38 correspond à un arc de cercle dont le centre est à l'extérieur des tranchées 12, 14. La troisième surface courbe 40 délimite une portion de volume convexe de la tranchée 14. Selon un mode de réalisation, dans le plan de coupe de la figure 4, la section de la troisième surface courbe 40 correspond à un arc de cercle dont le centre est à l'intérieur de la tranchée 14. Chaque portion 16 comprend donc une protubérance 41 qui pénètre dans les tranchées 12, 14 à l'intersection 22.

Lorsque la couche isolante 18 est présente, l'interface 42, qui sépare la couche isolante 18 du coeur 20 des tranchées 12, 14, épouse la forme de l'oreille 34, c'est-à-dire qu'elle comprend successivement une surface courbe 44 qui épouse la forme de la surface courbe 36, une surface courbe 46 qui épouse la forme de la surface courbe 38 et une surface courbe 48 qui épouse la forme de la surface courbe 40. On appelle rayon de sortie d'oreille r_{sortie_oreille} le rayon de courbure de la surface 44 ou 48 et on appelle rayon d'oreille rₒᵣₑiₗₗₑ le rayon de courbure de la surface 38. Le rayon rₒᵣₑᵢₗₗₑ est choisi pour obtenir la largeur E_{MAX} souhaitée. De préférence, la largeur E_{MAX} est de l'ordre de la largeur E des tranchées 12, 14. Le rayon r_{sortie_oreille} est choisi en fonction de l'intensité maximale des contraintes souhaitée dans le circuit électronique 30.

Selon un mode de réalisation, le rayon r_{sortie_oreille} est compris entre 100 nm et 500 nm, de préférence entre 200 nm et 400 nm, par exemple environ 300 nm. Selon un mode de réalisation, le rayon rₒᵣₑᵢₗₗₑ est compris entre 200 nm et 2 µm, de préférence entre 200 nm et 600 nm, plus préférentiellement entre 300 nm et 500 nm, par exemple environ 400 nm. La largeur E de chaque tranchée 12, 14 est comprise entre 0,5 µm et 10 µm, par exemple environ 2 µm. L'épaisseur E_{OX} de la couche isolante 18 est comprise entre 10 nm et 500 nm, de préférence entre 100 nm et 400 nm, par exemple environ 200 nm. La profondeur des tranchées 12, 14 dépend de l'application envisagée et de la largeur E des tranchées. A titre d'exemple, la profondeur des tranchées 12, 14 est comprise entre 2 µm et 150 µm et le rapport de forme « profondeur des tranchées/largeur des tranchées » peut ainsi être compris entre 1 et 40, par exemple 25.

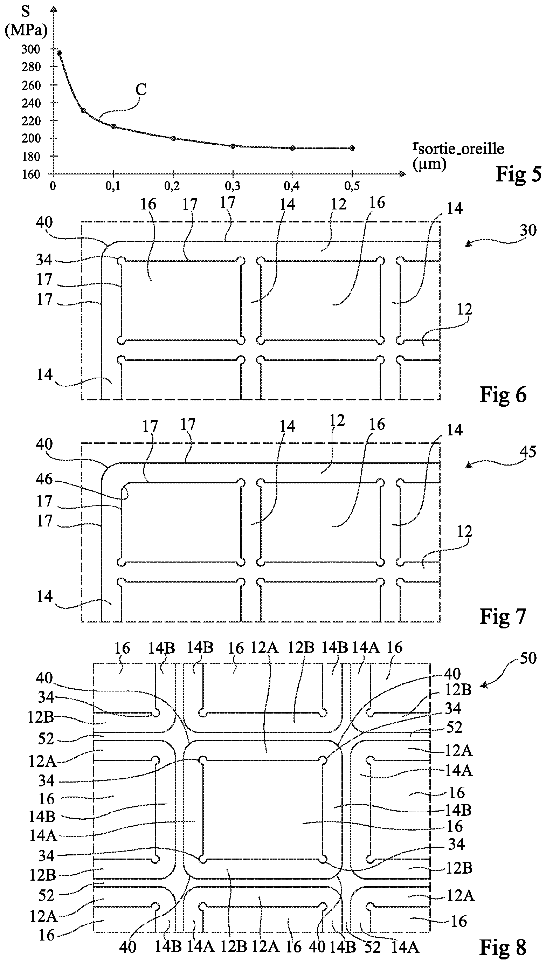

La figure 5 représente la courbe d'évolution C de l'intensité maximale de la contrainte S équivalente de Von Mises dans le circuit électronique 30 en fonction du rayon r_{sortie_oreille}. Le cas où le rayon r_{sortie_oreille} est sensiblement égal à 0 correspond au cas représenté en figure 1. La courbe C a été obtenue pour des portions 16 en silicium monocristallin, un coeur 20 en silicium polycristallin, une couche isolante 18 en oxyde de silicium avec une épaisseur E_{OX} égale à 200 nm, des tranchées 12, 14 ayant une largeur E de 2 µm et une largeur Eₘᵢₙ de 1,16 µm.

Lorsque le rayon r_{sortie_oreille} est supérieur à 100 nm, l'intensité maximale de la contrainte S équivalente de Von Mises est inférieure à 215 MPa et lorsque le rayon r_{sortie_oreille} est supérieur à 300 nm, l'intensité maximale de la contrainte S équivalente de Von Mises est inférieure à 186 MPa. Cette valeur de contrainte équivalente de Von Mises correspond à une contrainte principale en tension maximale d'environ 75 MPa. Cette valeur est inférieure aux contraintes maximales en tension acceptées par la plupart des matériaux utilisés pour la fabrication de circuits électroniques.

La figure 6 est une vue de dessus, partielle et schématique, du circuit électronique 30 dans laquelle on a représenté plusieurs portions 16 du substrat semiconducteur ou conducteur dont une portion qui est située au coin supérieur gauche du circuit électronique 30. En figure 6, la couche d'isolation 18 et le coeur 20 des tranchées 12, 14 ne sont pas représentés. Dans le présent mode de réalisation, pour les tranchées 12, 14 situées à au moins l'un des coins du circuit électronique 30, la jonction entre les parois latérales 17 des tranchées 12, 14 qui sont du côté de la portion semiconductrice ou conductrice 16 est réalisée par une oreille 34 tandis que la jonction entre les parois latérales 17 des tranchées 12, 14 qui sont du côté opposé à la portion 16 est réalisée par une zone arrondie 40. Le rayon de courbure de la zone arrondie 40 peut être sensiblement égal au rayon de courbure r_{sortie_oreille}. Dans le plan de coupe de la figure 6, la section de la zone arrondie 40 correspond, par exemple, à un arc de cercle.

La figure 7 est une vue de dessus, analogue à la figure 6, d'un autre mode de réalisation d'un circuit électronique 45. En figure 7, la couche d'isolation 18 et le coeur 20 des tranchées 12, 14 ne sont pas représentés. Le circuit électronique 45 comprend l'ensemble des éléments du circuit électronique 30 à la différence que, pour les tranchées 12, 14 situées à au moins l'un des coins du circuit électronique 30, la jonction entre les parois latérales 17 des tranchées 12, 14 qui sont du côté de la portion 16 est réalisée par une zone arrondie 46 correspondant, par exemple, à un secteur cylindrique dont l'axe est situé dans la portion 16. Dans le plan de coupe de la figure 7, la section de la zone arrondie 46 correspond, par exemple, à un arc de cercle.

La figure 8 est une vue de dessus, analogue à la figure 4, d'un autre mode de réalisation d'un circuit électronique 50. En figure 8, la couche d'isolation 18 et le coeur 20 des tranchées 12, 14 ne sont pas représentés. Les éléments communs avec le circuit électronique 30 sont désignés par les mêmes références. Dans le présent mode de réalisation, deux tranchées parallèles sont disposées entre les portions 16 semiconductrices ou conductrices d'une paire de portions adjacentes. Chaque portion 16 est donc entourée par des tranchées d'isolation électrique formant un cadre comprenant une tranchée supérieure 12A, une tranchée inférieure 12B, une tranchée latérale à gauche 14A et une tranchée latérale à droite 14B. Chaque tranchée 12A, 12B, 14A, 14B peut avoir la structure de la tranchée 12 ou 14 décrite précédemment.

Selon un mode de réalisation, les tranchées 12A, 12B, 14A, 14B entourant une portion semiconductrice ou conductrice 16 sont séparées des tranchées 12A, 12B, 14A, 14B entourant une portion 16 adjacente par une bande 52 du substrat 6. Pour les parois latérales 17 des tranchées 12A, 12B, 14A, 14B situées du côté de la portion 16, la jonction entre la paroi latérale 17 d'une tranchée 12A ou 12B et la paroi latérale 17 d'une tranchée 14A ou 14B est réalisée par une oreille 34 tandis que, pour les parois latérales 17 des tranchées 12A, 12B, 14A, 14B situées du côté opposé à la portion 16, la jonction entre la paroi latérale 17 d'une tranchée 12A ou 12B et la paroi latérale 17 d'une tranchée 14A ou 14B est réalisée par une zone arrondie 40.

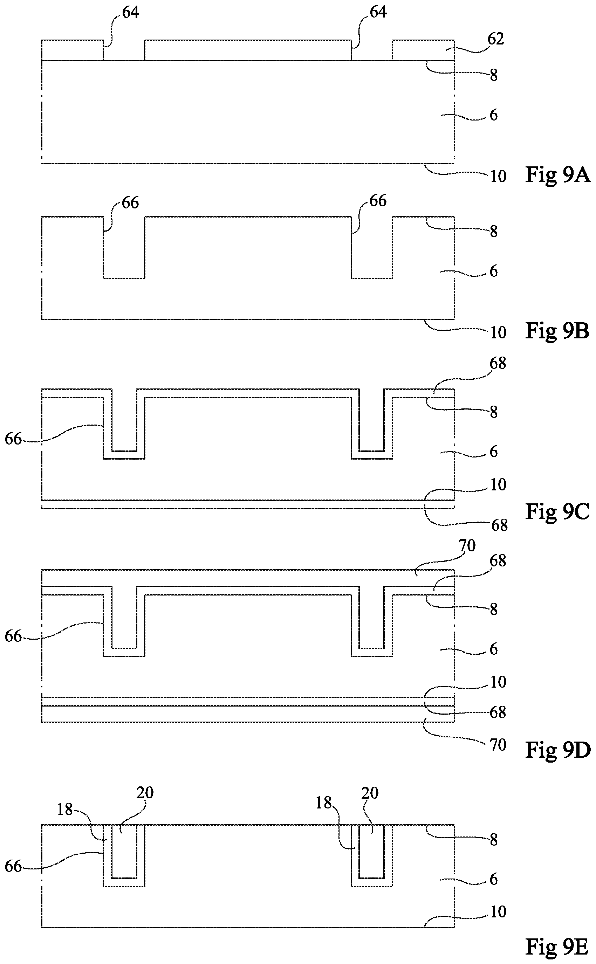

Les figures 9A à 9E illustrent un procédé de fabrication du circuit électronique 30 représenté en figure 4. Le même procédé peut être mis en oeuvre pour la fabrication des circuits électroniques 45 et 50.

La figure 9A représente la structure obtenue après avoir formé, sur la face avant 8 du substrat 6, une couche 62 d'une résine photosensible et après avoir formé par photolithogravure des ouvertures 64 dans la couche de résine 62 aux emplacements souhaités des tranchées 12, 14.

Le substrat 6 peut correspondre à une structure monobloc ou correspondre à une couche recouvrant un support constitué d'un autre matériau. Le substrat 6 est de préférence un substrat semiconducteur, par exemple un substrat en silicium, en germanium, en carbure de silicium, en un composé III-V, tel que du GaN ou du GaAs, ou un substrat en ZnO. De préférence, le substrat 6 est un substrat de silicium monocristallin. De préférence, il s'agit d'un substrat semiconducteur compatible avec les procédés de fabrication mis en oeuvre en microélectronique. Le substrat 6 peut correspondre à une structure multicouches de type silicium sur isolant, également appelée SOI (acronyme anglais pour Silicon On Insulator). Le substrat 6 peut être fortement dopé, faiblement dopé ou non dopé.

La figure 9B représente la structure obtenue après avoir gravé des ouvertures 66 dans le substrat 6, par exemple par une gravure sèche profonde, dans le prolongement des ouvertures 64 et après avoir retiré la couche de résine 62.

Selon une variante, un masque dur peut être utilisé. Dans ce but, une couche d'un matériau de préférence diélectrique peut être déposée sur la face 8 du substrat 6 avant le dépôt de la couche de résine 62, des premières ouvertures étant gravées dans le masque dur dans le prolongement des ouvertures 64 et des deuxièmes ouvertures étant gravées dans le substrat 6 dans le prolongement des premières ouvertures.

La figure 9C représente la structure obtenue après avoir formé une couche isolante électriquement 68 sur la totalité du substrat 6 et, notamment, dans les ouvertures 66. La couche isolante 68 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), ou en oxyde d'hafnium (HfO₂). La couche isolante 68 peut avoir une structure monocouche ou correspondre à un empilement de deux couches ou de plus de deux couches. Selon le procédé mis en oeuvre pour la formation de la couche isolante 68, celle-ci peut également être formée du côté de la face arrière du substrat 6.

Selon un mode de réalisation, la couche isolante 68 est obtenue par une étape d'oxydation thermique. A titre de variante, la couche isolante 68 peut être formée par un procédé du type dépôt chimique en phase vapeur (CVD, sigle anglais pour Chemical Vapor Déposition), notamment le dépôt chimique en phase vapeur assisté par plasma (PECVD, sigle anglais pour Plasma-Enhanced Chemical Vapor Déposition).

La figure 9D représente la structure obtenue après avoir déposé une couche 70 d'un matériau de remplissage sur la totalité du substrat 6 et, notamment, dans les ouvertures 66. L'épaisseur de la couche 70 est choisie de façon que les ouvertures 66 recouvertes de la couche isolante 68 soient partiellement ou complètement remplies du matériau de remplissage. Le matériau de remplissage peut correspondre au matériau composant le substrat 6, notamment sous une forme polycristalline, ou être un autre matériau que celui composant le substrat. A titre d'exemple, le matériau de remplissage est du silicium polycristallin, dopé ou non. La couche 70 peut être formée par CVD.

La figure 9E représente la structure obtenue après avoir retiré les parties de la couche isolante 68 et les parties de la couche 70 de matériau de remplissage présentes sur le substrat 6 à l'extérieur des ouvertures 66 de façon à délimiter, pour chaque tranchée, la couche isolante 18 et le coeur 20. Ceci peut être réalisé par une gravure ou par un procédé de polissage mécano-chimique. Une étape ultérieure d'amincissement du substrat 6 peut être réalisée du côté de la face 10, par exemple jusqu'à atteindre les ouvertures 66 de façon que les tranchées d'isolation obtenues s'étendent sur la totalité de l'épaisseur du substrat aminci.

Des exemples d'application des tranchées d'isolation électrique décrites précédemment concernent des dispositifs optoélectroniques, notamment des écrans d'affichage ou des dispositifs de projection, comprenant des diodes électroluminescentes formées à partir d'éléments semiconducteurs tridimensionnels, par exemple des microfils, des nanofils, des éléments coniques ou des éléments tronconiques. Un mode de réalisation va être décrit pour des diodes électroluminescentes formées à partir de microfils ou de nanofils. Toutefois, ce mode de réalisation peut être mis en oeuvre pour des éléments tridimensionnels autres que des microfils ou des nanofils, par exemple des éléments tridimensionnels en forme de pyramide. En outre, un mode de réalisation va être décrit pour des diodes électroluminescentes comprenant chacune une coque qui entoure au moins partiellement le microfil ou le nanofil. Toutefois, ces modes de réalisation peuvent être mis en oeuvre pour des diodes électroluminescentes pour lesquelles la zone active est située dans la hauteur ou au sommet du microfil ou du nanofil.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

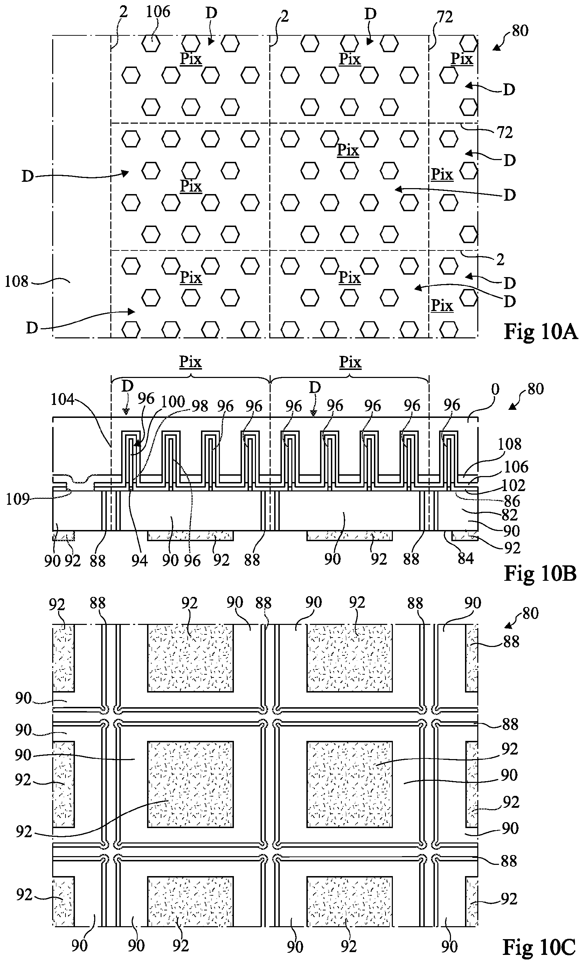

Les figures 10A à 10C représentent un mode de réalisation d'un dispositif optoélectronique 80, notamment un écran d'affichage ou un dispositif de projection, comprenant des tranchées d'isolation électrique telles que représentées sur la figure 4 ou 8.

Le dispositif optoélectronique 80 comprend :
- un substrat conducteur ou semiconducteur 82 comprenant une face inférieure 84 et une face supérieure 86 opposée, la face supérieure 86 étant de préférence plane au moins au niveau des ensembles de diodes électroluminescentes ;
- des tranchées 88 d'isolation électrique, ayant la structure représentée sur la figure 4 ou 8, qui s'étendent dans le substrat 82 entre les faces 84 et 86 et qui divisent le substrat 82 en portions 90 conductrices ou semiconductrices ;
- des plots conducteurs 92 au contact de la face inférieure 84, chaque portion 90 étant au contact de l'un des plots conducteurs 92 ;
- des plots de germination 94 favorisant la croissance de fils, chaque plot de germination 94 étant au contact de la face 86 sur l'une des portions 90 conductrices ou semiconductrices ;
- des fils 96, chaque fil 96 étant en contact avec l'un des plots de germination 94, chaque fil 96 comprenant une portion inférieure 98, en contact avec le plot de germination 94 et une portion supérieure 100, prolongeant la portion inférieure 98 ;
- une couche isolante électriquement 102 s'étendant sur la face 86 du substrat 82 et s'étendant sur les flancs latéraux de la portion inférieure 98 de chaque fil 96 ;
- une coque 104 comprenant un empilement de couches semiconductrices recouvrant la portion supérieure 100 de chaque fil 96 ;
- une couche 106 conductrice électriquement et au moins partiellement transparente formant une électrode recouvrant chaque coque 104, et s'étendant sur la couche isolante 102 entre les fils 96 ;
- une couche 108 conductrice électriquement recouvrant la couche d'électrode 106 entre les fils 96 mais ne s'étendant pas sur les fils 96, la couche conductrice 108 étant, en outre, au contact de l'une des portions semiconductrices 90 au travers d'une ouverture 109 prévue dans la couche d'électrode 106 et dans la couche isolante 102 ; et
- une couche d'encapsulation 110 transparente recouvrant l'ensemble de la structure.

Le dispositif optoélectronique 80 peut, en outre, comprendre une couche de luminophores, non représentée, et/ou des filtres colorés, non représentés, dans la couche d'encapsulation 110 ou sur la couche d'encapsulation 110. Selon un mode de réalisation, des luminophores sont notamment répartis entre les fils 96.

Chaque fil 96 et la coque 104 associée constituent une diode électroluminescente élémentaire. Les diodes électroluminescentes élémentaires situées sur une même portion semiconductrice 90 forment un ensemble D de diodes électroluminescentes. Chaque ensemble D comprend donc plusieurs diodes électroluminescentes élémentaires connectées en parallèle. Le nombre de diodes électroluminescentes élémentaires par ensemble D peut varier de 1 à plusieurs milliers, typiquement de 25 à 100. Le nombre de diodes électroluminescentes élémentaires par ensemble D peut varier d'un ensemble à l'autre.

Chaque sous-pixel d'affichage Pix du dispositif optoélectronique 80 comprend l'une des portions 90 conductrices ou semiconductrices et l'ensemble D de diodes électroluminescentes reposant sur cette portion 90. En figure 10A, on a représenté de façon schématique la séparation entre les sous-pixels d'affichage Pix par des lignes en traits pointillés 112. Selon un mode de réalisation, la surface occupée par chaque sous-pixel Pix en vue de dessus peut varier de 3 µm par 3 µm à plusieurs mm² et typiquement de 10 à 100 µm².

Chaque diode électroluminescente élémentaire est formée d'une coque recouvrant au moins partiellement un fil. La surface développée des couches actives des diodes électroluminescentes élémentaires d'un ensemble D est supérieure à la surface du sous-pixel d'affichage comprenant cet ensemble D. L'intensité maximale lumineuse pouvant être fournie par le sous-pixel d'affichage peut donc être supérieure à celle d'un sous-pixel d'affichage réalisé avec une technologie de diode électroluminescente inorganique bidimensionnelle.

Les fils 96 sont, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils 96 peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 96 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (0) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Les fils 96 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La section droite des fils 96 peut avoir différentes formes, telles que, par exemple, une forme ovale, circulaire ou polygonale, notamment triangulaire, rectangulaire, carrée ou hexagonale. A titre d'exemple, en figure 10A, les fils sont représentés avec une section droite hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 96 peut être compris entre 50 nm et 5 µm. La hauteur de chaque fil 96 peut être comprise entre 250 nm et 50 µm. Chaque fil 96 peut avoir une structure semiconductrice allongée selon un axe sensiblement perpendiculaire à la face 86. Chaque fil 96 peut avoir une forme générale cylindrique. Les axes de deux fils 96 adjacents peuvent être distants de 0,5 µm à 10 µm et de préférence de 1,5 µm à 5 µm. A titre d'exemple, les fils 96 peuvent être régulièrement répartis, notamment selon un réseau hexagonal.

A titre d'exemple, la portion inférieure 98 de chaque fil 96 est majoritairement constituée du composé III-N, par exemple du nitrure de gallium, dopé du même type que le substrat 82, par exemple de type N, par exemple au silicium. La portion inférieure 98 s'étend sur une hauteur qui peut être comprise entre 100 nm et 25 µm.

A titre d'exemple, la portion supérieure 100 de chaque fil 96 est au moins partiellement réalisée dans un composé III-N, par exemple du GaN. La portion supérieure 100 peut être dopée de type N, éventuellement moins fortement dopée que la portion inférieure 98 ou ne pas être intentionnellement dopée. La portion supérieure 100 s'étend sur une hauteur qui peut être comprise entre 100 nm et 25 µm.

La coque 104 peut comprendre un empilement de plusieurs couches comprenant notamment :
- une couche active recouvrant la portion supérieure 100 du fil 96 associé ;
- une couche intermédiaire de type de conductivité opposé à la portion inférieure 98 et recouvrant la couche active ; et
- une couche de liaison recouvrant la couche intermédiaire et recouverte par l'électrode 106.

La couche active est la couche depuis laquelle est émise la majorité du rayonnement fourni par la diode électroluminescente élémentaire. Selon un exemple, la couche active peut comporter des moyens de confinement des porteurs de charge électrique, tels que des puits quantiques multiples. Elle est, par exemple, constituée d'une alternance de couches de GaN et de InGaN ayant des épaisseurs respectives de 5 à 20 nm (par exemple 8 nm) et de 1 à 15 nm (par exemple 2, 5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure 100 de type N de la jonction P-N ou P-I-N.

La couche de liaison peut correspondre à une couche semiconductrice ou à un empilement de couches semiconductrices et permet la formation d'un contact ohmique entre la couche intermédiaire et l'électrode 106. A titre d'exemple, la couche de liaison peut être dopée très fortement du type opposé à la portion inférieure 98 de chaque fil 96, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 106 est adaptée à polariser la couche active de chaque fil 96 et à laisser passer le rayonnement électromagnétique émis par les diodes électroluminescentes. Le matériau formant l'électrode 106 peut être un matériau transparent et conducteur tel que de l'oxyde d'indium-étain (ou ITO, acronyme anglais pour Indium Tin Oxide), de l'oxyde de zinc dopé à l'aluminium, au gallium ou à l'indium, ou du graphène. A titre d'exemple, la couche d'électrode 106 a une épaisseur comprise entre 5 nm et 200 nm, de préférence entre 20 nm et 50 nm.

La couche conductrice 108 correspond, de préférence à une couche métallique, par exemple en aluminium, en cuivre, en or, en ruthénium ou en argent, ou à un empilement de couches métalliques, par exemple en titane-aluminium, en silicium-aluminium, en titane-nickel-argent, en cuivre ou en zinc. A titre d'exemple, la couche conductrice 108 a une épaisseur comprise entre 20 nm et 1500 nm, de préférence entre 400 nm et 800 nm. La couche conductrice 68 n'est présente qu'entre les fils et ne recouvre pas la surface émissive de ces derniers. La couche conductrice 108 permet de réduire les pertes résistives lors de la circulation du courant. Elle a également un rôle de réflecteur pour renvoyer vers l'extérieur les rayons émis par les diodes électroluminescentes dans la direction du substrat.

La couche d'encapsulation 110 est réalisée en un matériau isolant au moins partiellement transparent. L'épaisseur minimale de la couche d'encapsulation 110 est comprise entre 250 nm et 50 µm de sorte que la couche d'encapsulation 110 recouvre complètement la couche d'électrode 106 au sommet des ensembles D de diodes électroluminescentes. La couche d'encapsulation 110 peut être réalisée en un matériau inorganique au moins partiellement transparent. A titre d'exemple, le matériau inorganique est choisi parmi le groupe comprenant les oxydes de silicium du type SiOₓ où x est un nombre réel compris entre 1 et 2 ou SiO_{y}N_{z} où y et z sont des nombres réels compris entre 0 et 1 et les oxydes d'aluminium, par exemple Al₂O₃. La couche d'encapsulation 110 peut être réalisée en un matériau organique au moins partiellement transparent. A titre d'exemple, la couche d'encapsulation 110 est un polymère silicone, un polymère époxyde, un polymère acrylique ou un polycarbonate.

Un mode de réalisation d'un procédé de fabrication du dispositif optoélectronique 80 est décrit dans la demande de brevet français FR14/63420.

Des modes de réalisation particuliers ont été décrits. Diverses variantes et modifications apparaîtront à l'homme de l'art. En particulier, bien que dans les modes de réalisation décrits précédemment, les tranchées 12 soient représentées perpendiculaires aux tranchées 14, il est clair que l'orientation des tranchées peut être différente. A titre d'exemple, les portions 16 peuvent avoir, en vue de dessus, une section hexagonale.

## Revendications

1. Circuit électronique (30 ; 45 ; 50) comprenant un substrat (6) semiconducteur ou conducteur ayant des première et deuxième faces (8, 10) opposées et au moins des première et deuxième tranchées (12, 14) d'isolation électrique, non parallèles, comprenant des parois (17), s'étendant dans le substrat depuis la première face, délimitant au moins une portion (16) du substrat et se rejoignant à une jonction (22), la portion du substrat comprenant une protubérance (41) pénétrant dans la jonction, dans lequel la première tranchée (12) comprend, du côté de ladite portion (16), une première paroi (17) plane et dans lequel la deuxième tranchée (14) comprend, du côté de ladite portion, une deuxième paroi plane (17), la première paroi plane étant reliée à la deuxième paroi plane par une surface (34) de liaison comprenant successivement, de la première paroi plane jusqu'à la deuxième paroi plane, une première surface courbe (36) délimitant une portion de volume convexe de la première tranchée, une deuxième surface courbe (38) délimitant une portion de volume concave de la jonction (22) et une troisième surface courbe (40) délimitant une portion de volume convexe de la deuxième tranchée, et dans lequel les première, deuxième et troisième surfaces (36, 38, 40) correspondent, dans un plan parallèle à la première face (8), respectivement à des premier, deuxième et troisième arcs de cercle.

2. Circuit électronique selon la revendication 1, dans lequel le rayon de courbure de la deuxième surface (38) est compris entre 200 nm et 2 µm.

3. Circuit électronique selon la revendication 1 ou 2, dans lequel le centre du premier arc de cercle est situé dans la première tranchée (12), dans lequel le centre du deuxième arc de cercle est situé dans la portion (16) et dans lequel le centre du troisième arc de cercle est situé dans la deuxième tranchée (14).

4. Circuit électronique selon l'une quelconque des revendications 1 à 3, dans lequel ladite jonction (22) correspond à une intersection entre les première et deuxième tranchées (12, 14), la première tranchée ayant une section droite de largeur réduite de part et d'autre de l'intersection et la deuxième tranchée ayant une section droite de largeur réduite de part et d'autre de l'intersection.

5. Circuit électronique selon la revendication 4 dans son rattachement à la revendication 2, dans lequel la surface de liaison (34) est reproduite aux quatre coins de l'intersection (22) .

6. Circuit électronique selon l'une quelconque des revendications 1 à 5, dans lequel les parois (17) des première et deuxième tranchées (12, 14) sont recouvertes d'une couche (18) d'un premier matériau isolant électriquement, le coeur (20) des première et deuxième tranchées étant rempli d'un deuxième matériau pouvant être différent du premier matériau.

7. Circuit électronique selon la revendication 6 dans son rattachement à la revendication 2, dans lequel l'interface (42) entre la couche isolante (18) et le coeur (20) comprend successivement des quatrième, cinquième et sixième surfaces (44, 46, 48) qui épousent respectivement la forme des première, deuxième et troisième surfaces (36, 38, 40).

8. Circuit électronique selon la revendication 7, dans lequel le rayon de courbure de la quatrième surface (44) et de la sixième surface (48) est compris entre 100 nm et 1 µm.

## Patentansprüche

1. Eine elektronische Schaltung (30; 45; 50) aufweisend einen Halbleiter- oder Leitersubstrat (6) mit ersten und zweiten gegenüberliegenden Oberflächen (8, 10) und wenigstens ersten und zweiten elektrischen Isolationsgräben (12, 14), die nicht parallel sind und Wände (17) aufweisen, die sich in dem Substrat von der ersten Oberfläche aus erstrecken, wenigstens einen Abschnitt (16) des Substrats begrenzen und sich an einer Verbindungsstelle (22) treffen, wobei der Abschnitt des Substrats einen Vorsprung (41) aufweist, der in die Verbindungsstelle eindringt, wobei der erste Graben (12) auf der Seite des Abschnitts (16) eine erste ebene Wand (17) aufweist und wobei der zweite Graben (14) auf der Seite des Abschnitts eine zweite ebene Wand (17) aufweist, wobei die erste ebene Wand mit der zweiten ebenen Wand über eine Verbindungsfläche (34) gekoppelt ist, die nacheinander von der ersten ebenen Wand zur zweiten ebenen Wand folgendes aufweist eine erste gekrümmte Fläche (36), die einen Teil mit konvexem Volumen des ersten Grabens begrenzt, eine zweite gekrümmte Fläche (38), die einen Teil mit konkavem Volumens der Verbindungsstelle (22) begrenzt, und eine dritte gekrümmte Fläche (40), die einen Abschnitt mit konvexem Volumen des zweiten Grabens begrenzt, und wobei die ersten, zweiten und dritten Flächen (36, 38, 40) in einer Ebene parallel zu der ersten Fläche (8) jeweils einem ersten, zweiten und dritten Kreisbogen entsprechen.

2. Elektronische Schaltung nach Anspruch 1, wobei der Krümmungsradius der zweiten Oberfläche (38) im Bereich von 200 nm bis 2 µm liegt.

3. Elektronische Schaltung nach Anspruch 1 oder 2, wobei der Mittelpunkt des ersten Kreisbogens in dem ersten Graben (12) liegt, wobei der Mittelpunkt des zweiten Kreisbogens in dem Abschnitt (16) liegt und wobei der Mittelpunkt des dritten Kreisbogens in dem zweiten Graben (14) liegt.

4. Elektronische Schaltung nach einem der Ansprüche 1 bis 3, wobei die Verbindungsstelle (22) einem Schnittpunkt zwischen den ersten und zweiten Gräben (12, 14) entspricht, wobei der erste Graben einen Querschnitt mit verringerter Breite auf beiden Seiten des Schnittpunkts aufweist und der zweite Graben einen Querschnitt mit verringerter Breite auf beiden Seiten des Schnittpunkts aufweist.

5. Elektronische Schaltung nach Anspruch 4 und nach Anspruch 2, wobei sich die Verbindungsfläche (34) an den vier Ecken des Schnittpunkts (22) wiederholt.

6. Elektronische Schaltung nach einem der Ansprüche 1 bis 5, wobei die Wände (17) der ersten und zweiten Gräben (12, 14) mit einer Schicht (18) aus einem ersten elektrisch isolierenden Material bedeckt sind, wobei der Kern (20) der ersten und zweiten Gräben mit einem zweiten Material gefüllt ist, das sich von dem ersten Material unterscheiden kann.

7. Elektronische Schaltung nach Anspruch 6 und nach Anspruch 2, wobei die Grenzfläche (42) zwischen der Isolierschicht (18) und dem Kern (20) nacheinander vierte, fünfte und sechste Flächen (44, 46, 48) aufweist, die jeweils die Form der ersten, zweiten und dritten Fläche (36, 38, 40) annehmen.

8. Elektronische Schaltung nach Anspruch 7, wobei der Krümmungsradius der vierten Fläche (44) und der sechsten Fläche (48) im Bereich von 100 nm bis 1 µm liegt.

## Claims

1. An electronic circuit (30; 45; 50) comprising a semiconductor or conductive substrate (6) having first and second opposite surfaces (8, 10) and at least first and second electric insulation trenches (12, 14), not parallel, comprising walls (17), extending in the substrate from the first surface, delimiting at least a portion (16) of the substrate and joining at a junction (22), the portion of the substrate comprising a protrusion (41) penetrating into the junction, wherein the first trench (12) comprises, on the side of said portion (16), a first planar wall (17) and wherein the second trench (14) comprises, on the side of said portion, a second planar wall (17), the first planar wall being coupled to the second planar wall by a connection surface (34) successively comprising, from the first planar wall to the second planar wall, a first curved surface (36) delimiting a portion of convex volume of the first trench, a second curved surface (38) delimiting a portion of concave volume of the junction (22), and a third curved surface (40) delimiting a portion of convex volume of the second trench, and wherein the first, second, and third surfaces (36, 38, 40) correspond, in a plane parallel to the first surface (8), respectively to first, second, and third arcs of a circle.

2. The electronic circuit of claim 1, wherein the radius of curvature of the second surface (38) is in the range from 200 nm to 2 µm.

3. The electronic circuit of claim 1 or 2, wherein the center of the first arc of a circle is located in the first trench (12), wherein the center of the second arc of a circle is located in the portion (16), and wherein the center of the third arc of a circle is located in the second trench (14).

4. The electronic circuit of any of claims 1 to 3, wherein said junction (22) corresponds to an intersection between the first and second trenches (12, 14), the first trench having a cross-section of decreased width on either side of the intersection and the second trench having a cross-section of decreased width on either side of the intersection.

5. The electronic circuit of claim 4 and of claim 2, wherein the connection surface (34) is repeated at the four corners of the intersection (22).

6. The electronic circuit of any of claims 1 to 5, wherein the walls (17) of the first and second trenches (12, 14) are covered with a layer (18) of a first electrically-insulating material, the core (20) of the first and second trenches being filled with a second material capable of being different from the first material.

7. The electronic circuit of claim 6 and of claim 2, wherein the interface (42) between the insulating layer (18) and the core (20) successively comprises fourth, fifth, and sixth surfaces (44, 46, 48) which respectively take the shape of the first, second, and third surfaces (36, 38, 40).

8. The electronic circuit of claim 7, wherein the radius of curvature of the fourth surface (44) and of the sixth surface (48) is in the range from 100 nm to 1 µm.
